(19) **Europäisches Patentamt**

**European Patent Office**

**Office européen des brevets**

(11) **EP 0 927 359 B1**

(12) **EUROPÄISCHE PATENTSCHRIFT**

(45) Veröffentlichungstag und Bekanntmachung des Hinweises auf die Patenterteilung:
**24.10.2001 Patentblatt 2001/43**

(51) Int Cl.⁷: **G01R 31/28**, G01R 31/02, B60R 21/00

(21) Anmeldenummer: **97935450.3**

(22) Anmeldetag: **22.07.1997**

(86) Internationale Anmeldenummer:
**PCT/DE97/01538**

(87) Internationale Veröffentlichungsnummer:
**WO 98/12569 (26.03.1998 Gazette 1998/12)**

(54) **SCHALTUNGSANORDNUNG ZUR WIDERSTANDS- UND LECKMESSUNG**

CIRCUIT TO MEASURE RESISTANCE AND LEAKAGE

CIRCUIT POUR MESURER LA RESISTANCE ET LES FUITES

(84) Benannte Vertragsstaaten:
**DE FR GB IT**

(30) Priorität: **19.09.1996 DE 19638393**

(43) Veröffentlichungstag der Anmeldung:
**07.07.1999 Patentblatt 1999/27**

(73) Patentinhaber: **SIEMENS AKTIENGESELLSCHAFT**
**80333 München (DE)**

(72) Erfinder: **HERMANN, Stefan**
**D-93096 Koefering (DE)**

(56) Entgegenhaltungen:
**EP-A- 0 398 824          EP-A- 0 701 928**

- **BECKER: "DETECTION OF SHORTED COMPONENTS IN PARALLELL CIRCUITS" IBM TECHNICAL DISCLOSURE BULLETIN., Bd. 17, Nr. 9, Februar 1975, NEW YORK US, Seiten 2526-2527, XP002047503**

## Beschreibung

Die Erfindung betrifft eine Schaltungsanordnung zur Widerstands- und Leckmessung gemäß Oberbegriff des Anspruchs 1.

Vielfach werden Widerstands- und Leckwiderstandsmessungen mittels Gleichstrommessungen ausgeführt. Da ein ausreichender Signal/Rausch-Abstand sichergestellt werden muß, wird mit hohen Signalpegeln gemessen. Hierdurch ergibt sich eine unerwünscht hohe elektromagnetische Abstrahlung. Hinzu kommt, daß die benötigten Generatoren mit Gleichstromanteil und die Verstärker sehr aufwendig sind.

Bei einer in der EP-A 0 689 058 beschriebenen Schaltungsanordnung zum Überwachen eines Schaltungspunktes auf einen Störzustand in Form eines Leckwiderstandes ist eine eine Stromquelle aufweisende Prüfanordnung mit dem Schaltpunkt gekoppelt und eine Auswerteanordnung mit wenigstens einem Komparator vorgesehen. Der verwendete Prüfstrom zu einem Pol der Betriebsspannung ist ein Gleichstrom mit einem vorgegebenen Wert und fließt nur, wenn die Spannung zwischen dem Schaltungspunkt und dem Pol einen vorgegebenen Grenzwert unterschreitet. Eine Überschreitung dieses Spannungsgrenzwertes durch einen Leckstrom führt zu einer Spannungsänderung am Komparator. Bei dieser Schaltungsanordnung ist zur Überwachung des Schaltungspunktes auf einen Leckwiderstand gegen jeden der beiden Pole der Betriebsspannung eine zweite Stromquelle mit entgegengesetztem Prüfstrom vorgesehen, wobei vorzugsweise ein Fensterkomparator eingesetzt wird.

Aus der DE-A 195 17 141 ist eine Schaltungsanordnung zum Überwachen eines Zündpillenwiderstandes eines Airbag-Steuergeräts bekannt. Ein Prüfstrom wird abwechselnd aus zueinander entgegengesetzten Richtungen in den Zündpillenwiderstand eingespeist. Jeder am Widerstand gemessene Spannungswert wird zusammen mit einer positiven Bezugsspannung differentiell verstärkt. Eine Differenz zwischen den verstärkten Spannungen wird berechnet, die gleich einem Spannungswert ist, der durch einen Prüfstrom mit doppeltem Pegel hervorgerufen würde.

Aus einem weiteren Dokument (Becker: "Detection of shorted Components in parallel Circuits", IBM Technical Disclosure Bulletin, Bd. 17, Nr. 9, Februar 1975, New York, S. 2526-2527) ist ein Meßverfahren zur Erkennung von Leckwiderständen bei einer von zwei untersuchten gleichen Komponenten bekannt. Hierbei werden die beiden zu untersuchenden Bauteile parallel geschlossen, mit einem Wechselstrom-Rechtecksignal beaufschlagt und ein dabei möglicherweise auftretender unterschiedlicher Spannungsabfall mit einem Korrelator gemessen.

Aus der EP-A-0 701 928 ist eine weitere Schaltungsanordnung zum Testen eines Zündpillenwiderstandes eines Airbag-Steuergerätes bekannt, bei der die Ladedauer eines mit dem Zündpillenwiderstand in Serie geschalteten Kondensators mit den gemessenen Ladezeiten zweier Vergleichswiderstände verglichen wird. Diese Vergleichswiderstände repräsentieren jeweils einen oberen bzw. einen unteren zulässigen Grenzwert, innerhalb derer sich der Wert des Zündpillenwiderstandes befinden darf.

Der Erfindung liegt die Aufgabe zugrunde, eine Schaltungsanordnung zur Widerstands- und Leckmessung zu schaffen, die eine Messung mit niedrigen Signalpegeln ermöglicht und zugleich einfach und kostengünstig aufgebaut ist.

Diese Aufgabe ist erfindungsgemäß bei einer Schaltungsanordnung mit den Merkmalen des Anspruchs 1 gelöst.

Vorteilhafte Weiterbildungen der Schaltungsanordnung sind Gegenstand der Unteransprüche.

Bei der erfindungsgemäßen Schaltungsanordnung wird ein Breitband-Signalgenerator eingesetzt, der sein Wechselstromsignal der Stromquelle aufprägt. Dadurch entfallen aufwendige Generatoren und Verstärker mit Gleichstromanteil und die Schaltungskosten sind geringer. Darüber hinaus kann durch die Messung mit einem Breitbandsignal eine hohe elektromagnetische Abstrahlung vermieden werden und zugleich eine niedrige elektromagnetische Empfindlichkeit erhalten werden.

Es ist möglich, einen analogen Signalgenerator, beispielsweise einen Zufallsgenerator mit analogen Werten und Digital/Analog-Umsetzer zu verwenden. Vorzugsweise wird jedoch ein digitaler Signalgenerator vorgesehen, der weniger Schaltungsaufwand mit sich bringt und beispielsweise die Signalpegel +1 und -1 ausgibt. Eine mögliche Realisierung ist ein rückgekoppeltes Register mit Länge n und Taktfrequenz F. Die Bandbreite des Signals kann dann bei einem solchen Register zwischen F und $F/(2^n-1)$ liegen.

Das getaktete Ausgangssignal des Signalgenerators wird auf die Stromquelle gegeben, die entsprechende Stromsignale ausgibt. Der durch diesen Wechselstromsignale erzeugte Spannungsabfall wird zwischen den beiden Schaltungspunkten von dem Spannungsverstärker erfaßt und dem Korrelator zugeführt.

Das Prinzip der erfindungsgemäßen Schaltungsanordnung ist folgendes: Wenn im Idealfall (kein Leck, keine Fremdsignale im untersuchten Schaltungsabschnitt) am Verstärker das reine, ungedämpfte Prüfsignal mit dem aufgeprägten Generatorsignal erhalten wird, ergibt sich in Kombination mit dem direkt auf den Korrelator gegebenen Generatorsignal eine 100 %ige Übereinstimmung, somit ein maximales Korrelatorsignal. Der Korrelator untersucht die zeitverschobenen Signalwerte und unterdrückt nichtkorrelierte Signalwerte. Fremdsignale wie z.B. statistisch unabhängige Rauschsignale werden ausgeblendet und es wird nur der Signalanteil berücksichtigt, der von dem Stromquellensignal herrührt. Werden reine Störsignale in den Korrelator gegeben, ergibt sich somit eine Übereinstimmung von 0 % mit dem Generatorsignal und am Ausgang des Korrelators ein Signal mit minimalem Pegel. Wenn es ein Leck und keine Störsignale gibt, dann gibt es ein Ausgangssignal mit hohem Pegel, da eine Korrelation zu dem Stromquellensignal besteht. Im Fall eines Lecks und von gleichzeitigen Störsignalen ergibt sich am Ausgang des Korrelators indessen ein Signal mit niedrigem Pegel.

Ein Beispiel eines Korrelators ist der Aufbau mit einem Multiplizierer und einem nachgeschalteten Tiefpaßfilter. Der Multiplizierer multipliziert die beiden eingegebenen Signale, deren Zusammenhang geprüft werden soll. Im nachgeschalteten Filter erfolgt eine Integration bis zur Grenzfrequenz, wobei die Störanteile ausgefiltert werden.

Die erfindungsgemäße Schaltungsanordnung ist insbesondere für ein Airbag-Steuergerät vorgesehen. Mit ihr kann beispielsweise der Zündpillenwiderstand gemessen werden. Des weiteren können Leckströme in der Auslöseschaltung festgestellt werden, und zwar kann eine Leckmessung zwischen der Zündpille und Masse und zwischen der Zündpille und dem Batteriespannungspol durchgeführt werden. Bedarfsweise kann darauf verzichtet werden, zwischen einem Leck zum Masseanschluß und zum Batteriespannungsanschluß zu unterscheiden. Es sind dann nur zwei Meßteile der Schaltungsanordnung erforderlich, d.h. zwei Korrelatoren, zwei Stromquellen, etc..

Die Messungen des Zündpillenwiderstandes und der Leckwiderstände können bei Vorliegen jeweils unkorrelierter Generatorsignale gleichzeitig durchgeführt werden. Es ist auf diese Weise möglich, gleichzeitig den Zündpillenwiderstand und/oder die Leckwiderstände in bezug auf den Masse- und den Batteriespannungsanschluß zu messen. In einem solchen Fall sind dann die Generatorsignale zeitverschoben, z.B. aus verschiedenen Registerausgängen. Wird mit nur einem Generatorsignal gearbeitet, müssen die Messungen zeitlich nacheinander erfolgen.

Die erfindungsgemäße Schaltungsanordnung ermöglicht es, eine dauernde Widerstands- und/oder Leckwiderstandsmessung durchzuführen. Aufgrund der Verwendung von Breitbandsignalen ist die Schaltungsanordnung dabei weniger störempfindlich als im Fall von Gleichstrommessungen.

Soll die Meßgenauigkeit erhöht werden, kann eine Zwei-Punkt-Messung durchgeführt werden. Es werden dann unterschiedliche Ströme eingespeist. Hierzu kann beispielsweise das der Stromquelle zugeführte Signal aus dem Signalgenerator mit unterschiedlichen Faktoren multipliziert werden. Wenn R der gesuchte Widerstand ist, U die Spannung und I der Strom, ergibt sich

$$R = (U_2 - U_1) / (I_2 - I_1)$$

Eine solche Zwei-Punkt-Messung ermöglicht es, den Einfluß beispielsweise einer Offsetspannung zu eliminieren.

Bevorzugte Ausführungsbeispiele der Erfindung werden im folgenden anhand der Zeichnung erläutert. Es zeigen

Figur 1:  Ein schematisches Blockschaltbild eines ersten Ausführungsbeispiels der erfindungsgemäßen Schaltungsanordnung,

Figur 2:  Eine schematische Darstellung eines Beispiels eines Korrelators für die Schaltung von Fig. 1,

Figur 3:  Eine schematische Darstellung eines Beispiels eines Signalgenerators für die Schaltung von Fig. 1,

Figur 4:  Ein schematisches Schaltbild eines zweiten Ausführungsbeispiels der erfindungsgemäßen Schaltungsanordnung.

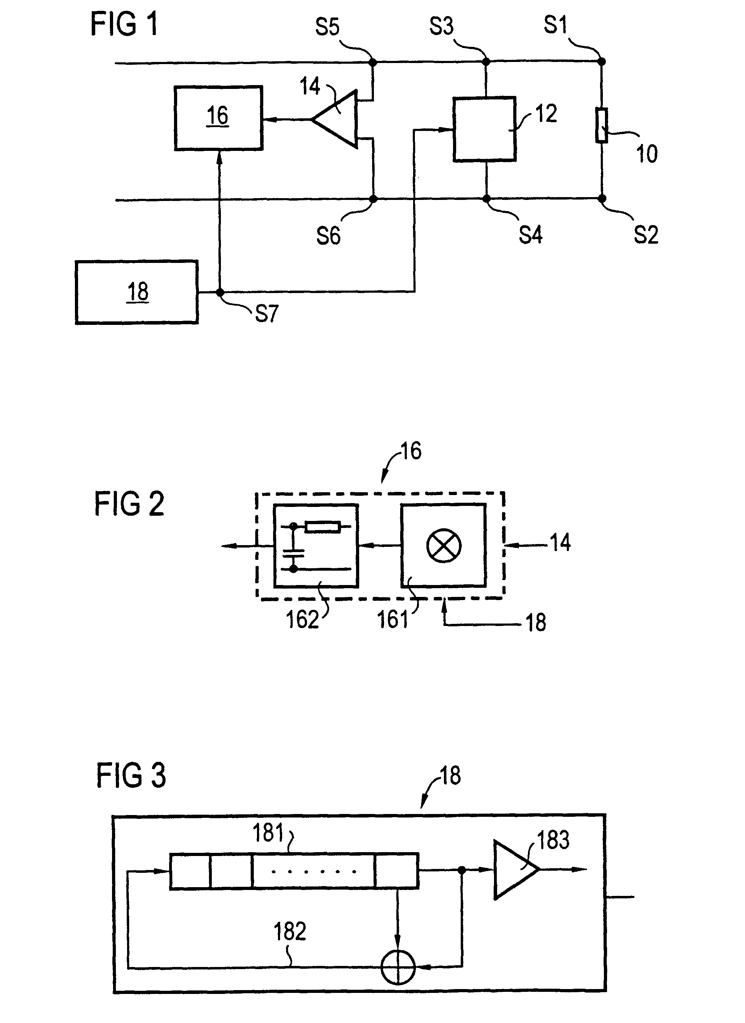

Im folgenden wird die Schaltungsanordnung zur Widerstands- und Leckmessung für Airbag-Steuergeräte beschrieben. Figur 1 zeigt anhand eines Blockschaltbilds den Grundaufbau der Schaltungsanordnung. 10 bezeichnet einen Schaltungsabschnitt, dessen Widerstand gemessen werden soll, mit Schaltungspunkten S1 und S2. Parallel angeschlossen ist eine Stromquelle 12 mit Schaltungspunkten S3 und S4. Die Stromquelle 12 hat einen Steuereingang für ihre Aktivierung. Ein Verstärker 14 ist zwischen den Schaltungspunkten S1 und S2 angeschlossen und ist mit einem Eingang eines Korrelators 16 verbunden, dessen Ausgang zu einer nicht dargestellten Auswerteeinheit führt. Ein Breitband-Signalgenerator 18 ist über seinen Ausgang mit einem zweiten Eingang des Korrelators 16 und mit dem Steuereingang der Stromquelle verbunden.

Der Signalgenerator 18 bewirkt einen Stromfluß der Stromquelle 12 (z.B. 20 mA), wobei der Strom ohne Gleichstromkomponente ist und durch den zu prüfenden Schaltungsabschnitt 10 fließt und zwischen den Schaltungspunkten S1 und S2 einen Spannungsabfall bewirkt. Dieser Spannungsabfall wird über den Verstärker 14 erfaßt und das Verstärkerausgangssignal auf den Korrelator gegeben, dem außerdem das Ausgangssignal des Signalgenerators zugeführt wird.

Wenn der Korrelator 16 zusätzlich zu dem Ausgangssignal des Signalgenerators ein Spannungssignal erhält, das die Prüfstromkomponente enthält, stellt der Korrelator eine Korrelation fest und gibt ein entsprechendes Korrelationssignal aus, beispielsweise mit hohem Pegel. Ist die Prüfstromkomponente nicht vorhanden, hat das Korrelationssignal einen niedrigen Pegel.

Figur 2 zeigt ein Beispiel eines Korrelators, der bei der Schaltungsanordnung von Figur 1 verwendet werden kann. Er umfaßt einen Multiplizierer 161, der die beiden Eingangssignale vom Verstärker 14 und Signalgenerator 18 multipliziert, und ein Filter 162, das eine Integration des vom Multiplizierer 161 erhaltenen Produkts über die Zeit durchführt. Veranschaulicht ist im dargestellten Beispiel ein Tiefpaßfilter. In bekannter Weise kann die Berechnung auch im Frequenzbereich durchgeführt werden.

Figur 3 zeigt ein Beispiel eines Funktionsgenerators 18, der vorteilhaft für die Schaltungsanordnung von Figur 1 verwendet wird. Er umfaßt ein n-stelliges Register 181 (z.B. n = 8) mit Rückkopplungszweig 182 (Mitkopplung) und arbeitet mit einer Taktfrequenz F. Im gezeigten Beispiel ist die Taktfrequenz 10 kHz. Keinesfalls ist jedoch die Erfindung auf diese Frequenz oder diesen Frequenzbereich beschränkt. Das Registerausgangssignal wird über einen Verstärker 183 verstärkt. Der Signalgenerator 18 ist ein digitaler Baustein. Er gibt beispielsweise Signale +1 und -1 aus.

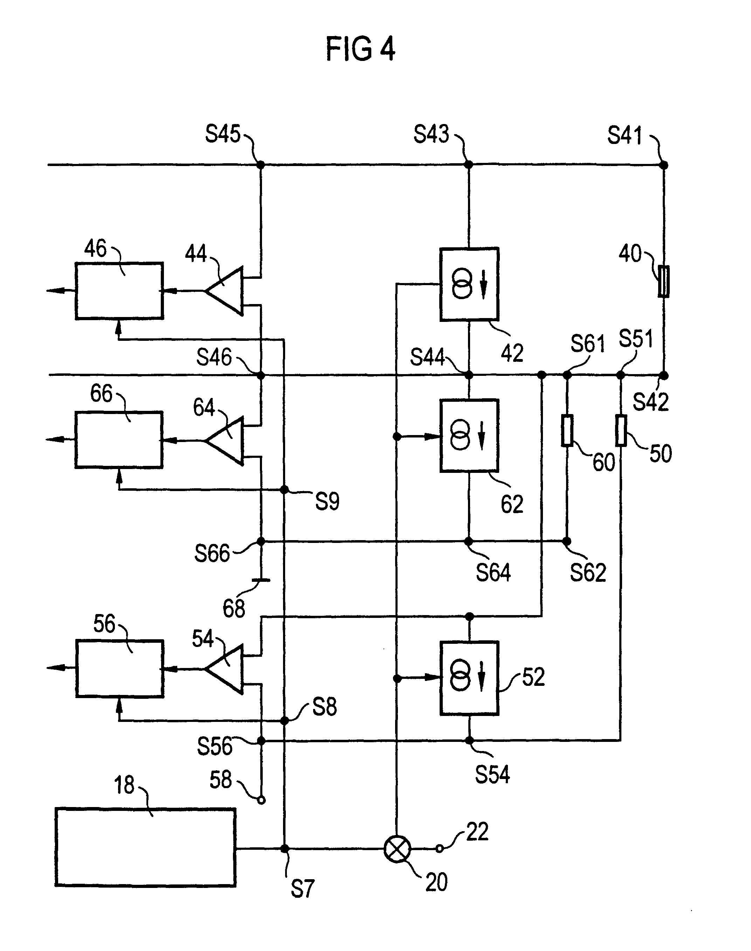

Ein Anwendungsbeispiel bei einem Airbag-Steuergerät ist in Fig. 4 dargestellt. Das dort dargestellte Schaltbild zeigt dreimal die Schaltungsanordnung von Fig. 1, wobei jedoch der Signalgenerator nur einmal vorhanden ist. Der zu messende Widerstand ist einmal der Zündpillenwiderstand 40, in den anderen beiden Fällen ein Leckwiderstand 50, 60 zur Batterie bzw. Masse. In gleicher Weise wie bei der Schaltungsanordnung von Figur 1 sind Stromquellen 42, 52 und 62, Verstärker 44, 54 und 64 sowie Korrelatoren 46, 56 und 66 vorgesehen. Die Leckwiderstände 50 und 60 werden zwischen der Lowside-Seite mit Schaltungspunkt 42 der Zündpille und dem Batteriepol 58 bzw. Masseanschluß 68 gemessen. Zur Verdeutlichung sind Schaltungspunkte S51, S53, S54, S56 und S58, S61, S62, S64, S66 und S68 eingezeichnet.

Der Ausgang des Signalgenerators 18 ist über Schaltungspunkte S7, S8 und S9 mit den Korrelatoren 46, 56 und 66 verbunden. Des weiteren ist er über einen Multiplizierer 20 mit den Stromquellen 42, 52 und 62 verbunden. Auf den zweiten Eingang des Multiplizierers wird ein Signal KI von einem Steuereingang 22 aus gegeben, das z.B. einen Faktor 1 oder 2 darstellt (KI = 1 oder = 2). Die Verwendung des Faktors KI ermöglicht die Erzeugung von Stromquellensignalen unterschiedlicher Pegel und damit eine Zwei-Punkt-Messung zur Erhöhung der Meßgenauigkeit. Das Signal des Signalgenerators 18 wird gleichzeitig auf alle Korrelatoren und Stromquellen gegeben. Auf diese Weise kann simultan und zyklisch ein Lecktest durchgeführt werden, wobei die Stromquellen auch nur während dieser Zeitdauern aktiviert sein müssen.

Wenn bei der Leckstrommessung nicht zwischen Batteriespannung und Masse unterschieden werden muß, kann auf einen Schaltungszweig 52, 54, 56 oder 62, 64, 66 verzichtet werden.

## Patentansprüche

1. Schaltungsanordnung zur Widerstands- und/oder Leckmessung zwischen zwei Schaltungspunkten (S1, S2; S41, S42; S51, 58; S61, 68) in einem Airbag-Steuergerät, umfassend eine Stromquelle (12; 42; 52; 62) zur Einspeisung eines Prüfstroms in einen der beiden Schaltungspunkte und ein Schaltglied (14; 44; 54; 64), das die sich aus dem Prüfstrom und dem Widerstand zwischen den beiden Schaltungspunkten ergebende Spannung erfaßt, **dadurch gekennzeichnet, daß** ein Breitband-Signalgenerator (18) vorgesehen ist, dessen Ausgang mit dem Steuereingang der Stromquelle (12; 42; 52; 62) verbunden ist und der Ausgang des Schaltglieds (14; 44; 54; 64) und des Signalgenerators mit den Eingängen eines Korrelators (16; 46; 56; 66) für eine Korrelation ihrer Ausgangssignale verbunden sind.

2. Schaltungsanordnung nach Anspruch 1, **dadurch gekennzeichnet, daß** das Schaltglied (14; 44; 54; 64) einen Spannungsverstärker umfaßt.

3. Schaltungsanordnung nach Anspruch 2, **dadurch gekennzeichnet, daß** der Verstärker (14; 44; 54; 64) ein Operationsverstärker ist.

4. Schaltungsanordnung nach Anspruch 1, **dadurch gekennzeichnet, daß** der Signalgenerator (18) ein digitaler Signalgenerator ist.

5. Schaltungsanordnung nach Anspruch 4, **dadurch gekennzeichnet, daß** der Signalgenerator (18) ein rückgekoppeltes Register (181) mit Registerlänge n und Taktfrequenz F umfaßt.

6. Schaltungsanordnung nach Anspruch 1, für eine Messung zwischen mindestens jeweils zwei weiteren Schaltungspunkten (S51, 58; S61, 68), **dadurch gekennzeichnet, daß** die Stromquelle (12; 42) jeweils mindestens eine weitere Stromquelle (52; 62) umfaßt, jeweils mindestens ein weiterer Korrelator (56; 66) über ein seinem einen Eingang vorgeschaltetes Schaltglied (54; 64) mit den Schaltungspunkten verbunden ist und der Ausgang des Signalgenerators (18) mit dem zweiten Eingang des mindestens einen weiteren Korrelators und dem Steuereingang der mindestens einen weiteren Stromquelle verbunden ist.

7. Schaltungsanordnung nach Anspruch 6, **dadurch gekennzeichnet, daß** gleichzeitig unkorrelierte Signale von dem Signalgenerator (18) jeweils auf die Steuereingänge der verschiedenen Stromquellen (42; 52; 62) gegeben werden, die jeweils zugleich auf die zugehörigen Korrelatoren (46; 56; 66) gegeben werden.

8. Schaltungsanordnung für eine Zwei-Punkt-Messung, **dadurch gekennzeichnet, daß** ein erster Eingang eines Multiplizierers (20) mit dem Ausgang des Signalgenerators verbunden ist und sein zweiter Eingang für ein Faktorwert-Signal vorgesehen ist.

## Claims

1.  Circuit arrangement for measuring resistance and/or leakage between two circuit points (S1, S2; S41, S42; S51,58; S61, 68) in an airbag control device, comprising a current source (12; 42; 52; 62) for feeding a test current into one of the two circuit points and a circuit element (14; 44; 54; 64) which detects the voltage resulting from the test current and the resistance between the two circuit points, **characterized in that** a broadband signal generator (18) is provided, the output of which is connected to the control input of the current source (12; 42; 52; 62) and the output of the circuit element (14; 44; 54; 64) and of the signal generator are connected to the inputs of a correlator (16; 46; 56; 66) for correlating their output signals.

2.  Circuit arrangement according to Claim 1, **characterized in that** the circuit element (14; 44; 54; 64) comprises a voltage amplifier.

3.  Circuit arrangement according to Claim 2, **characterized in that** the amplifier (14; 44; 54; 64) is an operational amplifier.

4.  Circuit arrangement according to Claim 1, **characterized in that** the signal generator (18) is a digital signal generator.

5.  Circuit arrangement according to Claim 4, **characterized in that** the signal generator (18) comprises a feedback-type register (181) having a register length n and clock frequency F.

6.  Circuit arrangement according to Claim 1 for measuring between at least in each case two further circuit points (S51, 58; S61, 68), **characterized in that** the current source (12; 42) in each case comprises at least one further current source (52; 62), in each case at least one further correlator (56; 66) is connected to the circuit points via a circuit element (54; 64) connected in front of its one input and the output of the signal generator (18) is connected to the second input of the at least one further correlator and the control input of the at least one further current source.

7.  Circuit arrangement according to Claim 6, **characterized in that** uncorrelated signals from the signal generator (18) are in each case applied simultaneously to the control inputs of the various current sources (42; 52; 62) which are in each case at the same time applied to the associated correlators (46; 56; 66).

8.  Circuit arrangement for a two-point measurement, **characterized in that** a first input of a multiplier (20) is connected to the output of the signal generator and its second input is provided for a factor-value signal.

## Revendications

1.  Circuit pour mesurer la résistance et/ou mesurer des fuites entre deux points de circuit (S1, S2; S41, S42; S51, 58; S61, 68) dans un appareil de commande de coussin gonflable, comportant une source de courant (12; 42; 52; 62) pour alimenter en courant de contrôle un des deux points de circuit, et une unité de circuit (14; 44; 54; 64), qui mesure la tension provenant du courant de contrôle et de la résistance entre les deux points de circuit, **caractérisé en ce qu'**il est prévu un générateur de signal à large bande (18), dont la sortie est reliée à l'entrée de commande de la source de courant (12; 42; 52; 62), et **en ce que** la sortie de l'unité de circuit (14; 44; 54; 64) et celle du générateur de signal sont reliées aux entrées d'un corrélateur (16; 46; 56; 66), pour effectuer la corrélation de leurs signaux de sortie.

2.  Circuit suivant la revendication 1, **caractérisé en ce que** l'unité de circuit (14; 44; 54; 64) comporte un amplificateur de tension.

3.  Circuit suivant la revendication 2, **caractérisé en ce que** l'amplificateur (14; 44; 54; 64) est un amplificateur opérationnel.

4.  Circuit suivant la revendication 1, **caractérisé en ce que** le générateur de signaux (18) est un générateur de signaux numériques.

5.  Circuit suivant la revendication 4, **caractérisé en ce que** le générateur de signaux (18) comporte un registre à rétroaction (181), comportant une longueur de registre n et travaillant avec une fréquence d'horloge F.

6.  Circuit suivant la revendication 1, pour effectuer une mesure entre chaque fois au moins deux autres points de circuit (S51, 58; S61, 68), **caractérisé en ce que** la source de courant (12; 42) comporte, chaque fois, au moins une autre source de courant (52; 62), **en ce que en ce que**, chaque fois, au moins un autre corrélateur (56; 66) est relié aux points de circuit par l'intermédiaire d'une unité de circuit (54; 64) connectée en amont de l'une de ces entrées, et **en ce que** la sortie du générateur de signal (18) est reliée à la deuxième entrée d'au moins cet autre corrélateur, et à l'entrée d'au moins cette autre source de courant.

7. Circuit suivant la revendication 6, **caractérisé en ce que** des signaux non corrélés simultanément sont envoyés par le générateur de signal (18) chacun sur les entrées de commande des différentes sources de courant (42; 52; 62), ces signaux étant chaque fois, en même temps envoyés sur les corrélateurs associés (46; 56; 66).

8. Circuit pour effectuer une mesure en deux points, **caractérisé en ce qu'**une première entrée d'un multiplicateur (20) est reliée à la sortie du générateur de signal et **en ce que** sa deuxième entrée est prévue pour un signal de valeur de facteur.

FIG 1

S5    S3    S1

16    14    12    10

S6    S4    S2

18    S7

FIG 2

16

14

162    161    18

FIG 3

18

181    183

182

# FIG 4